Europäisches Patentamt

European Patent Office

Office européen des brevets

(11) Publication number: **0 419 763 A1**

# EUROPEAN PATENT APPLICATION

(21) Application number: **90110182.4**

(22) Date of filing: **29.05.90**

(51) Int. Cl.⁵: **H01L 21/90, H01L 21/285**

(30) Priority: **29.09.89 US 416331**

(43) Date of publication of application:
**03.04.91 Bulletin 91/14**

(84) Designated Contracting States:
**DE FR GB**

(71) Applicant: **International Business Machines Corporation**
**Old Orchard Road**
**Armonk, N.Y. 10504(US)**

(72) Inventor: **Aboelfotoh, Mohamed Osama**
**4 Timberline Drive**
**Poughkeepsie, New York 12603(US)**

(74) Representative: **Klocke, Peter, Dipl.-Ing.**
**IBM Deutschland GmbH Patentwesen und**
**Urheberrecht Schönaicher Strasse 220**
**W-7030 Böblingen(DE)**

(54) **A stable interconnection metallization for VLSI devices including copper.**

(57) Cu silicide (26) or germanide (46) is formed on the surface of a single crystalline semiconductor substrate of Si or Ge, respectively, to act as an interconnection metallization for integrated circuits. Cu (30, 44) is deposited on the Si or Ge substrate as a film while the substrate is held at room temperature. It has been found that the materials will react by themselves over an extended period of time to form a Cu-silicide (26) or Cu-germanide (46) compound interface junction, but, in the context of existing VLSI processes, heat is used to accelerate the formation using the minimum desirable parameters of a temperature of about $150\,^{\circ}C$ for about 20 minutes. Contrary to the belief in the art that Cu always diffuses in silicon, the resulting interface junction has been found to demonstrate superior (near ideal) current/voltage characteristics and can be used as a high temperature $(600\text{-}800\,^{\circ}C)$ stability Ohmic/Schottky contact to Si or as a Cu diffusion barrier. Additional embodiments involve a Cu layer on a Ge layer on Si substrate, a Cu layer on a $Si_xGe_{1-x}$ layer on Si substrate, and the use of an intermediate layer of a refractory metal such as W.

## FIG. 5

## FIG. 9

# A STABLE INTERCONNECTION METALLIZATION FOR VLSI DEVICES INCLUDING COPPER

The invention relates to VLSI technology and more particularly to the use of copper as interconnection metallization in silicon (Si), germanium (Ge), and $Si_xGe_{1-x}$ electronic devices.

The metal copper (Cu) has very good electrical conductivity and as a result there is currently a wide interest in and effort toward developing Cu as interconnection metallization in future Si, Ge, and $Si_xGe_{1-x}$ electronic devices. However, it is known that Cu diffuses into Si, producing deep energy levels in the Si energy gap which can act as efficient recombination centers thus effecting minority-carrier lifetime. This, in turn, results in severe degradation of the electrical characteristics of such devices as metal-Si Schottky-barrier and p-n junctions. Also, it is known that Cu in Ge introduces several acceptor energy levels in the energy band gap of Ge. Such energy levels similarly can act as recombination centers or as traps giving rise to excess current which causes severe degradation of the electrical characteristics of such devices as np and metal-Ge Schottky-barrier junctions.

Following from the experience and belief in the art that Cu always diffuses in silicon and other single crystalline semiconductor materials, a problem has existed in the art to create Cu-semiconductor interfaces in VLSI devices while avoiding degradation of current-voltage characteristics in such devices. The process and system of the present invention offer a solution to this problem.

In accordance with the present invention, junctions formed by the deposition of Cu on a single crystalline semiconductor substrate, e.g., Si, at room temperature, are treated, such as by maintaining them at room temperature for extended periods or accelerating the process by annealing, e.g., at 200°C for 30 min., to convert the as-deposited Cu/Si interface into a well-reacted silicide $(Cu_3Si)/Si$ interface. In the as-deposited state, these junctions display highly nonideal current-voltage characteristics, that is, they exhibit large excess current under forward and reverse bias conditions; but, it has been found that, remarkably, simple treatment, e.g., by low-temperature annealing, results in junctions which exhibit ideal current-voltage characteristics. Characterization of these junctions using techniques such as deep-level transient spectroscopy reveals that such low-temperature annealing causes the disappearance of the deep energy levels which are believed to be acting as efficient recombination centers giving rise to large excess current under forward and reverse bias conditions. Moreover, the ideal current-voltage characteristics displayed by the comparatively low-temperature, 200°C - annealed junctions are found to remain unaffected by further annealing of the junctions at higher temperatures such as 600°C for 30 min. These findings are very significant in that they show that copper, through the vehicle of the resulting silicide interface, can be used as an "electrically" stable interconnection metallization in future VLSI devices, e.g., as a high temperature (600-800°) stability Ohmic/Schottky contact to Si or as a Cu diffusion barrier.

Similarly, as in the case of Cu on Si, it has been found that annealing junctions formed by the deposition of Cu on Ge, at temperatures as low as 150°C to 200°C, to form $Cu_xGe_{1-x}$ compounds results in junctions which exhibit ideal current-voltage characteristics. Also, the ideal current-voltage characteristics displayed by junctions annealed at such low temperatures are found to remain unaffected by further annealing the junctions up to 600°C. This demonstrates the feasibility of using $Cu_xGe_{1-x}$ as electrically stable contact and interconnection metallization in future Ge and $Ge_xSi_{1-x}$ devices.

Additional embodiments can include a Cu layer on a Ge layer on Si substrate, a Cu layer on a $Si_xGe_{1-x}$ layer on Si substrate, and the use of an intermediate layer of a refractory metal such as tungsten (W).

Consequently, it has been found that a Cu interconnection metallization for integrated circuits can be formed by depositing a Cu film on a single crystalline semiconductor substrate held at room temperature, and treating the Cu coated substrate to form a Cu-semiconductor compound interface junction which has ideal current-voltage characteristics.

The present invention as claimed therefore involves a system and method for forming an interconnection metallization for integrated circuits wherein a Cu film is deposited on a single crystalline semiconductor layer or substrate, e.g., of Si or Ge, held at room temperature, and the Cu-coated substrate is treated to form a Cu-semiconductor compound interface junction. The treatment may consist of merely maintaining the Cu-coated substrate at room temperature for an extended period, e.g., at least about two hours, but typically several hours and perhaps for weeks, depending on the thickness of the Cu film. However, in keeping with present processes for manufacturing VLSI devices, the formation of the interface junction may be accelerated by heating the Cu-coated substrate to a temperature of at least about 150°C for at least about 20 minutes, and preferably to 200°C for 30 min., to form a Cu-semiconductor compound interface junction.

For a better understanding of the present invention, together with further objects and advantages, preferred embodiments of the invention described in the following with reference to the accompanying drawings, in which:

Figure 1 is a cross-sectional view of a VLSI device with an upper Cu layer deposited on a Si layer in accordance with one embodiment of the present invention wherein the layer of Si is first deposited on top of a W layer which is currently used to contact p-n junctions in bipolar technology.

Figure 2 is a view as in Fig. 1 of the device after heating to form a copper silicide ($Cu_3Si$) layer in keeping with the invention.

Figure 3 is a cross-sectional view showing a device in accordance with an alternative embodiment of the invention wherein a layer of Si is first deposited over the entire Si substrate (or a layer of polyimide), and then a Cu layer is deposited on top of the Si layer.

Figure 4 is a view as in Fig. 3 of the device after heating to form a copper silicide $Cu_3Si$) layer in keeping with the invention.

Figure 5 is a view as in Fig. 4 wherein the formation of copper silicide is followed by the deposition of a W layer and then a second layer of Cu on top of the W layer.

Figure 6 is a cross-sectional view showing a FET device in accordance with a further embodiment of the invention using copper silicide ($Cu_3Si$) to contact source and drain regions and wherein a layer of Cu is first deposited over the entire Si substrate.

Figure 7 is a view as in Fig. 6 of the device after heating to form a copper silicide ($Cu_3Si$) layer in keeping with the invention and the excess Cu Si has been chemically removed.

Figure 8 is a cross-sectional view showing a device in accordance with another embodiment of the invention wherein $Cu_xGe_{1-x}$ is used as stable contact and interconnection metallization and a layer of Cu is first deposited over the exposed surface a $n^+$ diffused region formed in a p - type Ge substrate and over an oxide layer.

Figure 9 is a view as in Fig. 8 of the device after heating to form a layer of $Cu_xGe_{1-x}$ in keeping with the invention.

Figure 10 is a view as in Fig. 9 of the device after the excess unreacted Cu has been removed using an excimer laser to etch only in areas where the laser light impinges on the substrate.

Figure 11 is a cross-sectional view showing a $Ge_xSi_{1-x}$/Si junction in accordance with a further embodiment of the invention wherein a layer of Si or Ge is first deposited over the exposed surface of the $Ge_xSi_{1-x}$ layer through a window formed in the oxide layer and then followed by the deposition of a Cu layer.

Figure 12 is a view as in Fig. 11 of the device after heating to form a $Cu_xSi_{1-x}$ or $Cu_xGe_{1-x}$ contact metallization.

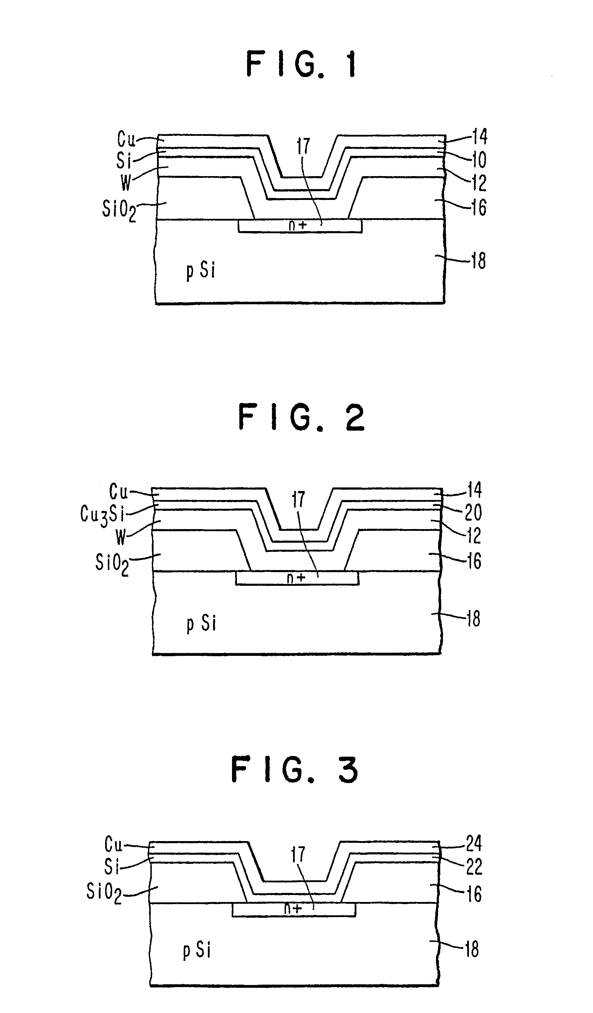

In one embodiment of the present invention Cu is deposited on Si to form a stable interconnection metallization in VLSI devices. As shown in Fig. 1, a layer 10 of Si, typically of ~ 300-500Å thickness, is first deposited on top of a layer 12 of refractory metal, W, which is currently used to contact p-n junctions in bipolar technology. This is followed by the deposition of a layer 14 of Cu, typically of ~ 3000-5000Å thickness, on top of the Si layer 10. The structure, which in the example also includes a Si oxide layer 16 and an $n^+$ diffused region 17 formed in a p - type Si substrate 18, is then heated to 200°C for 30 min. to form a copper silicide ($Cu_3Si$) layer 20 as shown in Fig. 2.

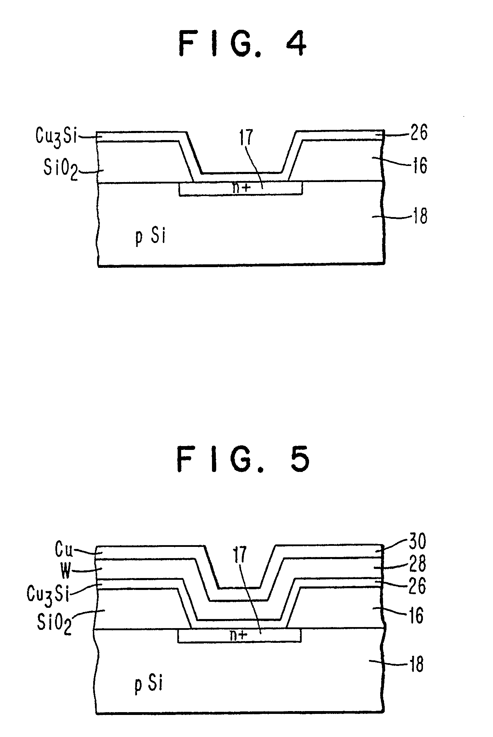

An alternative embodiment is illustrated in Fig. 3, wherein a layer 22 of Si (~ 300-500Å) is first deposited over the entire Si substrate, i.e., the Si oxide layer 16 and the exposed portions of the Si substrate 18, and then a layer 24 of Cu (~ 500-1500Å) is deposited on top of the Si layer as shown in the Figure. The structure is then heated to 200°C for 30 min. to form copper silicide ($Cu_3Si$) 26 as shown in Fig. 4. This is followed by the deposition of a layer 28 of W and then a second layer 30 of Cu (~ 300-500Å) on top of the W layer as shown in Fig. 5. This structure is found to be electrically stable up to 600°C for 30 min.

As an alternative to the Si oxide for layer 16, it has been found that if an insulating layer of polyimide is used, excellent adhesion between the silicide formed and the polyimide will be achieved.

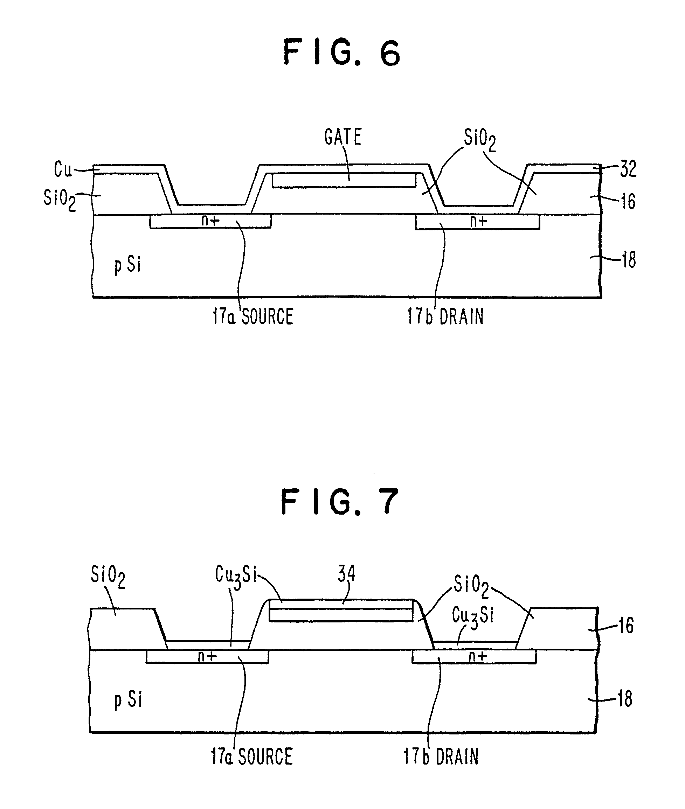

In FET devices, copper silicide ($Cu_3Si$) can be used to contact source and drain regions. An example is shown in Fig. 6 wherein a layer 32 of Cu (~ 500-1500Å) is first deposited over the entire Si substrate contacting source 17a and drain 17b regions in the exposed portions of substrate 18. The structure is then heated to 200°C for 30 min. to form copper silicide ($Cu_3Si$) 34 and the excess copper silicide is chemically removed, resulting in the structure shown in Fig. 7. Here, a substantial advantage over prior art is that ohmic contacts to source and drain regions can be achieved at very low temperatures, about 150 - 200°C, as compared to levels of 600°C to 700°C which are currently used in existing technology.

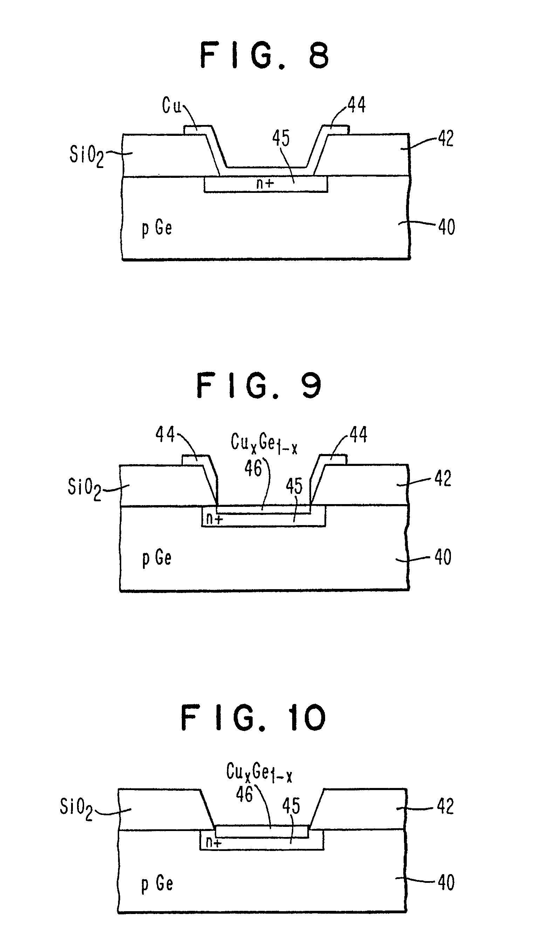

Figures 8 - 12 show examples of how $Cu_xGe_{1-x}$ can be used as stable contact and interconnection metallization in future devices. A layer 44 of Cu, as shown in Fig. 8, is first deposited to a thickness of ~ 2000 to 3000Å over the exposed surface of a $n^+$ diffused region 45 formed in a p - type Ge substrate 40 and over an oxide layer 42. The structure is then heated to 200°C to form a layer 46 of $Cu_xGe_{1-x}$ as shown in Fig. 9. The excess unreacted Cu is then removed using a technique which utilizes excimer laser such as KrF at 248 nm or ArF at 193 nm and selected Freon gases such as $CF_2Br_2$ as disclosed by J.H. Brannon in IBM TDB, vol. 28, No. 8, 1988. In such a process, etching takes place only in areas where the laser light is impinging on the substrate 40, allowing the use of a simple light-pattern forming system. This results in the structure shown in Fig. 10.

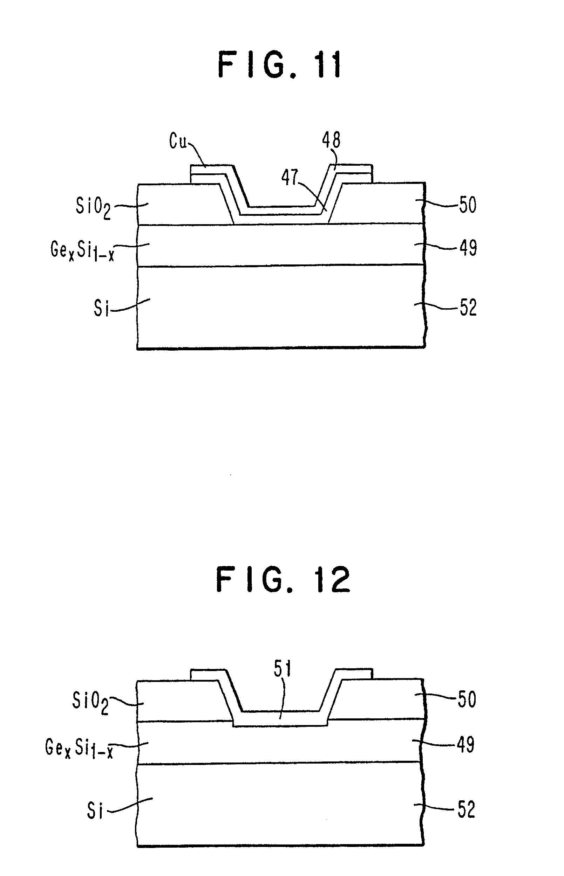

In the fabrication of $Ge_xSi_{1-x}/Si$ junctions, a layer 47 of Si or Ge, as shown in Fig. 11, is first deposited to a thickness of ~ 200 to 500Å over the exposed surface of a $Ge_xSi_{1-x}$ layer 49 through a window formed in the oxide layer 50, followed by a Cu layer 48 to a thickness of ~ 2000 to 3000Å. The structure disposed on substrate 52, e.g., of Si, is then heated to 200°C to form $Cu_xSi_{1-x}$ or $Cu_xGe_{1-x}$ contact metallization 51 as shown in Fig. 12.

Again, a substantial advantage here over prior art is that electrically stable contact metallization in Ge and $Ge_xSi_{1-x}$ devices is formed at low temperatures.

It will accordingly be seen that a system and process have been disclosed that provide a simple and electric ally stable interconnection metallization utilizing copper, which can be achieved with comparatively low-temperature annealing.

## Claims

1. A method of forming an interconnection metallization for integrated circuits comprising the steps of:
depositing a Cu film (14, 24, 30, 32, 44, 48) on a layer of a single crystalline semiconductor (10, 22, 47) held at room temperature; and
treating the Cu-coated semiconductor layer to form a Cu-semiconductor compound interface junction.

2. A method as in claim 1 wherein said treating step comprises maintaining the Cu-coated semiconductor layer at room temperature for at least about two hours.

3. A method as in claim 1 wherein said treating step comprises heating the Cu-coated semiconductor layer to a temperature of at least about 150°C for at least about 20 minutes to form a Cu-semiconductor compound interface junction.

4. A method as in claim 1 wherein said treating step comprises heating the Cu coated semiconductor layer to a temperature of about 200°C for about 30 minutes to form a Cu-semiconductor compound interface junction.

5. A method as in any one of the preceding claims wherein said semiconductor layer comprises silicon or germanium and said junction comprises $Cu_xSi_{1-x}$ or $Cu_xGe_{1-x}$ respectively.

6. A method as in any one of the preceding claims wherein said semiconductor layer is formed on a layer of W, or on a layer of polyimide.

7. A method as in any one of the claims 1 - 5 wherein said Cu film is deposited on regions of said semiconductor layer constituting source and drain regions of a FET for forming a contact therebetween.

8. A system of forming an interconnection metallization for integrated circuits comprising:
means for depositing a Cu film on a layer of a single crystalline semiconductor held at room temperature; and
means for treating the Cu-coated semiconductor layer to form a Cu-semiconductor compound interface junction by maintaining the Cu-coated semiconductor layer according to claims 2 - 4.

9. A system as in claim 8 wherein said means for treating comprises means for maintaining the Cu-coated semiconductor layer at room temperature for at least about two hours.

10. A system as in claim 8 wherein said means for treating comprises means for heating the Cu-coated semiconductor layer to a temperature of at least about 150°C for at least about 20 minutes or of about 200°C for about 30 minutes or to form a Cu-semiconductor compound interface junction.

# F I G. 1

# F I G. 2

# F I G. 3

# F I G. 4

# F I G. 5

# F I G. 6

# F I G. 7

# FIG. 8

Cu
44
45
SiO2
42
n+
p Ge
40

# FIG. 9

44
$Cu_x Ge_{1-x}$
44
46
SiO2
45
42
n+
p Ge
40

# FIG. 10

$Cu_x Ge_{1-x}$
46
45
SiO2
42
n+
p Ge
40

# FIG. 11

Cu
48
47
$SiO_2$ — — 50
$Ge_x Si_{1-x}$ — — 49
Si — — 52

# FIG. 12

51
$SiO_2$ — — 50
$Ge_x Si_{1-x}$ — — 49
Si — — 52

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | JOURNAL OF APPLIED PHYSICS vol. 67, no. 7, 01 April 1990, pages 3328 - 3336; A. CROS ET AL.: "Formation, oxidation, electronic, and electrical properties of copper silicides" * pages 3328 - 3329 * * page 3330, paragraph B * * page 3335, paragraph B * | 1, 4, 5, 8, 10 | H01L21/90 H01L21/285 |
| A | *idem * | 2, 9 | |
| P,X | JOURNAL OF APPLIED PHYSICS vol. 66, no. 7, 01 October 1989, pages 2989 - 2992; Chin-An CHANG: "Thermal stability of the Cu/PtSi metallurgy" * page 2989, paragraph II * * page 2991, left-hand column; figure 6 * | 1, 4, 5, 8, 10 | |
| X | APPLIED PHYSICS LETTERS vol. 41, no. 5, 01 September 1982, pages 440 - 442; R.D. THOMPSON et al.: "Low temperature gettering of Cu, Ag, and Au across a wafer of Si by Al" * pages 440 - 441; figure 1 * | 1, 5 | |
| A | * idem * | 8 | TECHNICAL FIELDS SEARCHED (Int. Cl.5) H01L C23C |
| A | EP-A-259616 (IBM) * column 2, line 42 - column 3, line 9; figures 1-3 * * column 4, line 28 - column 6, line 26 * * column 7, lines 24 - 51 * | 1, -3-5, 7, 8, 10 | |
| A | PATENT ABSTRACTS OF JAPAN vol. 6, no. 170 (E-128) 03 September 1982, & JP-A-57 087127 (SEIKO EPSON CORP.) 31 May 1982, * the whole document * | 1, 3, 4, 7, 8, 10 | |

The present search report has been drawn up for all claims

| Place of search | Date of completion of the search | Examiner |
|---|---|---|
| BERLIN | 17 DECEMBER 1990 | KLOPFENSTEIN P. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document